# EUROPEAN PATENT APPLICATION

(11) **EP 1 314 760 A1**
(43) Date of publication of application: **28.05.2003**
(21) Application number: 01961152.4
(22) Date of filing: 29.08.2001
(51) Int. Cl.: C08L 101/00, C08K 3/00, C08K 9/00, H05K 1/03, B32B 27/20

(54) **RESIN COMPOSITION, MOLDED OBJECT THEREOF, AND USE THEREOF**

(30) Priority: 29.08.2000 JP 2000259799; 17.07.2001 JP 2001216681
(71) Applicant: Otsuka Chemical Co., Ltd., Osaka-shi, Osaka 540-0021 (JP)
(72) Inventor: KAWAGUCHI, Akiyoshi, Tokushima-shi, Tokushima 771-0193 (JP); ISHII, Yoshiaki, Tokushima-shi, Tokushima 771-0193 (JP); TSUTSUMI, Hideyuki, Tokushima-shi, Tokushima 771-0193 (JP); TANAKA, Tomohiro, Tokushima-shi, Tokushima 771-0193 (JP); TAKENAKA, Minoru, Osaka-shi, Osaka 540-0021 (JP); INUBUSHI, Akiyoshi, Tokushima-shi, Tokushima 771-0193 (JP)
(74) Representative: Hucker, Charlotte Jane
(86) International application number: JP0107405
(87) International publication number: WO02018495

(57) **Abstract**

The present invention provides a resin composition comprising (A) at least one heat-resistant thermoplastic resin selected from the group consisting of a polyketone resin, a polyimide resin, polyethernitrile, polybenzimidazole, polyphenylene sulfide, polysulfone, polyethersulfone, polyarylate, a liquid crystal polyester resin, and 1,4-polyphenylene, and (B) a flaky inorganic filler that: (1) has a Mohs hardness of 3.0 or lower, (2) has a coefficient of linear expansion not higher than 5.0 x 10⁻⁵/K, (3) is chemically inert and retains a layer structure to at least 500°C, and (4) has an aspect ratio (the average particle diameter/thickness ratio) of 10 or higher; a formed article thereof; and a substrate film for printed circuit boards as use thereof.

## Description

### TECHNICAL FIELD

The present invention relates to a resin composition that are used for forming or sealing electrical, electronic and mechanical parts for industrial devices, such as communication devices and automotive devices; a formed article thereof; and a substrate film for printed circuit boards as use thereof.

### BACKGROUND ART

Plastic compositions comprising a plastic and an inorganic filler are widely used as important industrial composite materials.

In recent years, the rapid advance of technologies for controlling the form of inorganic fillers, in combination with the progress of polymer processing technologies for producing complexes and composites, makes it possible to develop high-performance composite materials. In particular, the technologies for controlling the form of inorganic fillers, as well as polymer alloy and nanocomposite technologies, have been newly recognized as very important technologies for producing modified or composite plastics.

Properties of inorganic fillers that generally influence the mechanical characteristics of inorganic filler-containing plastic compositions are: (1) the form of the fillers, (2) the particle diameter of the fillers, (3) the surface properties of the fillers, (4) the state of dispersion of the fillers in the compositions (morphology), (5) the interaction at the surface boundary of the plastic and filler, and the like. It is well known that, among these properties, the form of inorganic fillers greatly influences the mechanical characteristics of inorganic filler-containing plastic compositions.

Inorganic fillers are selected according to the intended use, by considering their inherent characteristics (electrical and electronic properties, thermal conductivity, flame retardancy, abrasion resistance, etc.) and form.

For example, as plastic compositions prepared in consideration of the inherent characteristics of inorganic fillers, Japanese Unexamined Patent publication No. 1991-287668 discloses a highly thermally conductive resin composition comprising a heat-resistant thermoplastic resin, a polyimide resin that is in a solution state at room temperature, and a highly thermally conductive inorganic filler, and Japanese Unexamined Patent Publication No. 2000-22289 discloses a resin composition for circuit boards comprising an epoxy resin and a boron nitride, which is well known as a thermally conductive filler.

These compositions are prepared by adding, as a thermally conductive filler, 10 to 75 vol.% of a known thermally conductive filler, such as a boron nitride, an aluminium nitride, or a magnesium oxide, relative to the total amount of the resin composition, to impart a desired thermal conductivity. The degree to which the inherent characteristics of the inorganic filler can be imparted to the resin composition increases proportionally to the amount of the inorganic filler added. However, it is difficult to achieve sufficient mechanical characteristics as a plastic composition merely by utilizing the inherent characteristics of an inorganic filler.

Known forms of inorganic fillers include fine particles, spherical particles, fibrous particles, flaky particles, and the like. The selection of the form is important in controlling the mechanical characteristics of plastic compositions.

As plastic compositions prepared in consideration of the form of inorganic fillers, resin compositions are widely known which are prepared by adding, to a heat-resistant resin, a reinforcing filler, such as a fibrous filler (e.g., a glass fiber, a potassium titanate fiber, β-wollastonite, etc.), or a flaky filler (e.g., natural mica, synthetic mica, talc, etc.), in a proportion of 5 to 70 wt.% relative to the total amount of the composition.

The fibrous filler remarkably improves the rigidity and deflection temperature under load of the resin composition, and reduces the mold shrinkage factor of the resin composition, but when used in an increased amount, markedly decreases the IZOD impact strength, elongation characteristics, and the like, making the resin composition susceptible to cracking. Further, the fibrous filler is disadvantageous in that it exhibits anisotropy and reduces the dimensional stability of the formed article. The flaky filler, when used in an increased amount, reduces the mold shrinkage factor, but greatly decreases the IZOD impact strength, elongation characteristics, and the like, and makes the resin composition susceptible to cracking.

Further, an oxide-type inorganic filler, such as glass fiber, potassium titanate fiber, or mica, has the problem that it produces hydroxyl groups on its surface by the interaction with moisture in the air, and depolymerizes the plastic that is being mixed with the filler, by hydrolysis or the like, thereby reducing the physical properties of the resin composition.

Electrical, electronic and mechanical parts for use in communication devices, automotive devices, and similar industrial devices are required to have high heat resistance, low coefficient of linear expansion, and such mechanical characteristics as high mechanical strength and high flexibility (i.e., large bending deflection and large tensile elongation). The coefficient of linear expansion is correlative to the mold shrinkage factor when producing a formed article from a resin composition. When the mold shrinkage factor is 0.30% or lower, the formed article has a coefficient of linear expansion not higher than 20 x 10⁻⁶/K. When a formed article of a resin composition has a bending deflection of 3.6% or more and a tensile elongation of 4.3% or more, the composition can be used as a forming or sealing material for electrical and electronic parts.

Therefore, it is necessary for a resin composition for use in such applications to have the above-specified mold shrinkage factor, bending deflection, and tensile elongation.

On the other hand, formed articles of resin compositions comprising a heat-resistant resin and an inorganic filler are often used as substrates for printed circuit boards.

Printed circuit boards with various structures are known. In particular, copper-clad laminates obtained by laminating a copper foil on one or both sides of a substrate and forming a circuit pattern on the copper foil are widely used in every electrical or electronic device.

Copper-clad laminates inherently has high reliability, but are required to have higher performance and a smaller size to cope with the ultrahigh-speed operation of computers that has accompanied the recent rapid increase in the amount of information being handled, and the remarkable spread of cellular phones and other mobile communication devices.

Known substrates for copper-clad laminates include, for example, those obtained by impregnating paper, glass fabric, nonwoven glass fabric, glass mat, or the like with an epoxy resin, a phenol resin, or the like. However, substrates obtained by impregnating paper with a phenol resin or an epoxy resin have a problem with hygroscopicity, and thus do not meet the demand for high performance. Substrates obtained by impregnating glass fabric or nonwoven glass fabric with an epoxy resin retain a good balance of the performance characteristics required of substrates for copper-clad laminates, but these substrates cannot satisfy the demand for miniaturization.

Besides those mentioned above, films obtained by forming a thermoplastic resin, such as polyester, polyimide, or polysulfone, or a mixture of such a thermoplastic resin and a suitable inorganic filler are known as substrates for copper-clad laminates. These thermoplastic resins have good formability, and thus can contribute to the miniaturization of communication devices or similar devices. Further, these resins can be easily multilayered to meet the demand for high performance. However, they are insufficient in heat resistance, and lack long-term durability and reliability.

Japanese Unexamined Patent Publication No. 1987-149436 proposes, as a substrate free from the above drawbacks, a film obtained by forming a resin composition comprising a mixed resin of polyetherimide and polyether ether ketone, and an inorganic filler, such as talc, silica powder, mica, or the like. The film has good heat resistance because polyether ether ketone is an engineering plastic with excellent heat resistance. Further, to prevent the film from curling when it is laminated with a copper foil, the coefficient of linear expansion of the film has been adjusted to a value similar to that of copper foils by adding a specific amount of the inorganic filler.

However, the addition of the inorganic filler to adjust the coefficient of linear expansion to a value similar to that of copper foils reduces the physical properties, such as elongation characteristics and deflection characteristics, of the film, leading to reduced durability. Thus, it is impossible to obtain a printed circuit board substrate film with long-term high reliability by the technique disclosed in the publication.

Japanese Unexamined Patent Publication No. 1991-20354 discloses a film obtained by forming a resin composition comprising a mixed resin of a polyether ketone resin, such as polyether ether ketone, and polyetherimide, and, as an inorganic filler, a boron nitride having an average major axis length of about 1 to 50 µm and an aspect ratio lower than 3. However, it is very difficult to adjust the coefficient of linear expansion of this film to a value similar to that of copper foils, and thus the film cannot be prevented from curling when laminated with a copper foil. Further, polyether ether ketone is slightly inferior in its processability for adhesion to a copper foil compared to other thermoplastic resins, and is used in combination with polyetherimide to improve the processability for adhesion. However, even the combined use cannot sufficiently improve the processability for adhesion, and therefore the film cannot fully meet the demand for the miniaturization of printed circuit boards.

### DISCLOSURE OF THE INVENTION

An object of the present invention is to provide a resin composition capable of forming a formed article that has high heat resistance, a low coefficient of linear expansion in the temperature range from room temperature to 230°C, and high mechanical strength, but has large bending deflection and large tensile elongation; and a formed article of the resin composition.

Another object of the present invention is to provide a substrate film for printed circuit boards that: has a coefficient of linear expansion similar to that of conductor layers, such as copper foils; is free from curling when laminated with a conductor layer; and has good elongation characteristics, good deflection characteristics, a low mold shrinkage factor, high heat resistance, good processability for adhesion to a metallic conductor, and the like.

Other objects and features of the invention will become apparent from the following description.

The present invention provides the following resin compositions, formed articles thereof, and substrate films for printed circuit boards as use thereof.
1. A resin composition comprising:
   (A) at least one heat-resistant thermoplastic resin selected from the group consisting of a polyketone resin, a polyimide resin, polyethernitrile, polybenzimidazole, polyphenylene sulfide, polysulfone, polyethersulfone, polyarylate, a liquid crystal polyester resin, and 1,4-polyphenylene; and
   (B) a flaky inorganic filler that: (1) has a Mohs hardness of 3.0 or lower, (2) has a coefficient of linear expansion not higher than 5.0 x 10⁻⁵/K, (3) is chemically inert and retains a layer structure to at least 500°C, and (4) has an aspect ratio (the average particle diameter/thickness ratio) of 10 or higher.
2. A resin composition according to Item 1, wherein the flaky inorganic filler (B) is at least one member selected from the group consisting of lamellar graphite, h-boron nitride, γ-boron nitride, t-boron nitride, lamellar boron-nitride and -carbide, and molybdenum disulfide.
3. A resin composition according to Item 1, wherein the proportion of the flaky inorganic filler (B) in the composition is 15 to 50 wt.%.
4. A resin composition according to Item 1, wherein the flaky inorganic filler has been subjected to a coupling treatment.
5. A resin composition according to Item 1, wherein the polyketone resin is at least one member selected from the group consisting of polyether ether ketone, polyether ketone, polyketone, and polyether ketone ketone.
6. A resin composition according to Item 1, wherein the polyimide resin is at least one member selected from the group consisting of polyimide, polyamide-imide, and polyetherimide.
7. A resin composition according to Item 1, wherein the component (A) is a polymer alloy of at least one heat-resistant crystalline resin selected from the group consisting of a polyketone resin, polyimide, polyamide-imide, polyethernitrile, polybenzimidazole, polyphenylene sulfide, a liquid crystal polyester resin, and 1,4-polyphenylene, and at least one heat-resistant amorphous resin selected from the group consisting of polysulfone, polyethersulfone, polyetherimide, and polyarylate.
8. A formed article obtainable by forming a resin composition according to item 1, the formed article having a mold shrinkage factor of 0.30% or lower, a bending deflection of 3.6% or more; and a tensile elongation of 4.3% or more.
9. A substrate film for printed circuit boards, obtainable by forming a resin composition comprising:
   (A') a heat-resistant thermoplastic resin that is a blended resin of a polyether ketone resin and
   polyetherimide; and
   (B') a flaky boron nitride that: (1) has a Mohs hardness of 3.0 or lower, (2) has a coefficient of linear expansion not higher than 5.0 x 10⁻⁵/K, (3) is chemically inert and
   retains a layer structure to at least 500°C; and (4) has an aspect ratio (the average particle diameter/thickness ratio) of 10 or lower.
10. A film according to Item 9, wherein the proportion of the polyether ketone resin in the blended resin is 30 to 70 wt.%.
11. A film according to Item 9, wherein the polyether ketone resin is at least one member selected from the group consisting of polyether ketone, polyether ether ketone, polyether ketone ketone, and polyether ether ketone ketone.
12. A film according to Item 9, wherein the proportion of the flaky boron nitride (B') in the composition is 15 to 40 wt.%.
13. A film according to Item 9, wherein the flaky boron nitride (B') is at least one member selected from the group consisting of h-boron nitride, γ-boron nitride, t-boron nitride, and lamellar boron-nitride and - carbide.
14. A resin composition according to Item 9, wherein the knee point of the resin composition is 60 MPa or less.
15. A printed circuit board comprising a substrate film according to item 9 and a conductor layer formed on the substrate film.
16. A printed circuit board according to Item 15, wherein the conductor layer is a copper foil.
17. A printed circuit board comprising a substrate film according to Item 9 and a conductor layer formed on the substrate film, the conductor layer having a circuit pattern.

The present inventors conducted extensive research to achieve the above objects, and found that the use of a resin composition comprising the above-specified (A) heat-resistance thermoplastic resin and (B) flaky inorganic filler makes it possible to produce a formed article that has high heat resistance, a low coefficient of linear expansion in the temperature range from room temperature to 230°C, and high mechanical strength, but has large bending deflection and large tensile elongation. The inventors further found that use of a resin composition comprising the above-specified (A') heat-resistant thermoplastic resin and (B') flaky boron nitride makes it possible to produce a substrate film for printed circuit boards that has a coefficient of linear expansion similar to that of conductor layers, such as copper foils, does not curl when laminated with a conductor layer, and has good elongation characteristics, good deflection characteristics, a low mold shrinkage factor, high heat resistance, good processability for adhesion to a metallic conductor, and the like.

The present invention has been accomplished based on these findings.

### Resin composition

The resin composition of the present invention comprises (A) a heat-resistance thermoplastic resin and (B) a flaky inorganic filler.

### (A) Heat-resistant thermoplastic resin

The heat-resistant thermoplastic resin (A) for use in the present invention is at least one resin selected from the group consisting of polyketone resins, polyimide resins, polyethernitrile, polybenzimidazole, polyphenylene sulfide, polysulfone, polyethersulfone, polyarylate, liquid crystal polyester resins, and 1,4-polyphenylene.

These heat-resistant resins are also called super engineering plastics, and have the highest level of heat resistance among thermoplastic resins. These resins are attracting attention as resins which have heat resistance (i.e., resistance to temperatures of 150°C or higher) comparable to that of thermosetting resins used for electrical and electronic parts or in the engine rooms of automotives for many years, and which meet the recent needs for recycling.

Polyketone resins usable in the present invention are engineering plastics having ketone groups (C=O) in the molecular structure. Specific examples of polyketone resins include polyether ether ketone, polyether ketone, polyether ketone ketone, and the like.

Polyether ether ketone (PEEK), which was developed by ICI in the U.K., is one of the highest performance crystalline thermoplastic resins, and is excellent especially in heat resistance and chemical resistance. PEEK has a molecular structure in which benzene rings are attached to one another at the para positions via rigid carbonyl groups or flexible ether linkages, and has a melting point of 344°C and a glass transition temperature of 143°C. Therefore, unreinforced PEEK has a deflection temperature under load of 140°C, which is not particularly high, but PEEK reinforced with 30 wt.% of glass fiber has a deflection temperature under load of 315°C, which is the highest among injection-moldable resins.

Polyether ketone (PEK) has a melting point of 373°C and a glass transition temperature of 162°C, thus has heat resistance higher than that of PEEK. Amoco and Dupont in the U.S. develop polyketone (PK) and polyether ketone ketone (PEKK), respectively.

The "polyimide resin" as used herein is a generic term for engineering plastics having imido groups in their molecular structures. Specific examples of polyimide resins include polyimide (PI), polyamide-imide (PAI), polyetherimide (PEI), and the like.

The heat resistance of polyimide resins is high because of the intermolecular force derived from the imido groups, and is further increased when an aromatic component is introduced. Polyimide resins usually contain a large proportion of aromatic components, and have a relatively symmetric molecular structure. PI has the highest heat resistance among all engineering plastics.

Polyimide resins have a deflection temperature under load of 290°C in an unreinforced state, and 330°C when reinforced with 50 wt.% of glass fiber. On the other hand, they are difficult to injection-mold. Therefore, attempts are being made to improve the moldability by making the resins melt-moldable, rendering the resins soluble in organic solvents, or other means. For example, PAI is a resin whose fluidity is increased to such an extent that it becomes injection-moldable, by introducing another component into the molecular structure.

Heat-resistant resins usable in the present invention include, in addition to polyketone resins and polyimide resins, polyethernitrile (PEN), polybenzimidazole (PBI), polyphenylene sulfide, polyaromatic resins, and the like. These resins are all heat-resistant crystalline resins.

Preferred examples of liquid crystal polyester resins for use in the present invention include those containing a segment represented by the formula 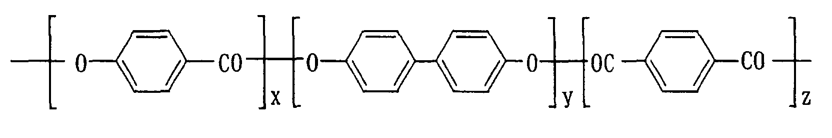 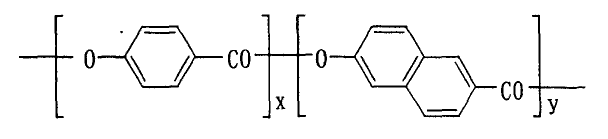 (wherein x, y, and z are each an integer of 5 to 10,000).

Specific examples of such liquid crystal polyester resins include those commercially available under the tradenames "Vectra" (Polyplastics, Co., Ltd.), "Rodrun" (Unitika, Ltd.), etc.

1,4-Polyphenylene for use in the present invention may be, for example, a rigid polymer commercially available under the tradename "Poly-X" (Maxdem Inc.).

In the present invention, polysulfone (PSF), polyethersulfone (PES), or polyarylate (PAR) can also be used as a heat-resistant resin. These resins and polyetherimide (PEI) are amorphous heat-resistant resins.

These amorphous heat-resistant resins have excellent heat resistance, a high glass transition temperature, and a high deflection temperature under load. Also, they have excellent dimensional accuracy, excellent dimensional stability, and high retentivity of mechanical characteristics at high temperatures, as characteristics of amorphous resins. Further, they are highly resistant to chemicals other than polar solvents. For example, aromatic PSF is highly transparent, and has a deflection temperature under load of 174°C in an unreinforced state, and as high as 181°C when reinforced with a glass fiber (30 wt.%).

PES is obtained by condensation polymerization reaction using dichlorodiphenyl sulfone as the main raw material, and has a deflection temperature under load of 203°C in an unreinforced state, and as high as 216°C when reinforced with a glass fiber (30 wt.%).

Polyetherimide, which has imide group, can be improved in formability by introducing ether group. The resulting resin has a deflection temperature under load of 200°C in an unreinforce state, and 210°C when reinforced with glass fiber (30 wt.%). This resin has physical properties similar to those of PES, but has a small specific gravity and a specific strength greater than that of PES.

Polyarylate (PAR) is an amorphous heat-resistant resin developed by Unitika, Ltd., and can be provided with heat resistance (a glass transition temperature of 190°C or higher) by varying the aromatic component.

In the present invention, a polymer alloy of a crystalline heat-resistant resin and amorphous heat-resistant resin may be used as the heat-resistant thermoplastic resin (A), so that the resin (A) has characteristics of both the crystalline heat-resistant resin and amorphous heat-resistant resin. Preferably usable is, for example, a polymer alloy of at least one heat-resistant crystalline resin selected from the group consisting of polyketone resins, polyimide, polyamide-imide, polyethernitrile, polybenzimidazole, polyphenylene sulfide, liquid crystal polyester resins, and 1,4-polyphenylene, and at least one heat-resistant amorphous resin selected from the group consisting of polysulfone, polyethersulfone, polyetherimide, and polyarylate.

### (B) Flaky inorganic filler

In the present invention, it is essential to use a flaky inorganic filler (B) that: (1) has a Mohs hardness of 3.0 or lower, (2) has a coefficients of linear expansion not higher than 5.0 x 10⁻⁵/K, (3) is chemically inert and retains a layer structure to at least 500°C, and (4) has an aspect ratio (the average particle diameter/thickness ratio) of 10 or higher.

According to research by the present inventors, a flaky inorganic filler to be added to the heat-resistant resin needs to satisfy the above requirements (1) to (4) from the following viewpoints.

(1) When the bending deflection and tensile elongation of a formed article of the resin composition according to the present invention are maintained at 3.6% or more and 4.3% or more, respectively, the formed article is free from the problem of cracking or brittleness and can be used in wide applications. For this purpose, the flaky inorganic filler itself needs to be soft. Specifically, a flaky inorganic filler with a Mohs hardness of 3.0 or lower is capable of maintaining the above-specified bending deflection and tensile elongation. Preferably, the Mohs hardness is 2.0 or lower.

(2) In order to reduce the mold shrinkage factor of the resin composition, it is necessary for the flaky inorganic filler to have a low coefficient of linear expansion. Specifically, a flaky inorganic filler with a coefficient of linear expansion not higher than 50 x 10⁻⁵/K, even when used in a small amount, can keep the mold shrinkage factor of the resin composition of the present invention low.

(3) The flaky inorganic filler is required to be chemically inert and retain a layer structure up to at least 500°C.

Generally, when a flaky inorganic filler comprising a metal oxide as the main ingredient is added to a resin, the bending deflection and tensile elongation of the formed article of the resin is likely to decrease. This is presumably because the metal oxide reacts with moisture in the air to generate a metal hydroxide, which attacks the main chain structure of the resin and causes deterioration. However, a flaky inorganic filler that retains a chemically stable layer structure when heated to at least 500°C does not adversely affect the physical properties, such as bending deflection and tensile elongation, of the formed article.

As used herein, the expression "chemically inert" means that a layer structure is stable (a layer structure is retained without being broken) during kneading (pelletization) or formed article extrusion. Whether the layer structure is retained or not is determined from a scanning electron microscope (SEM) photograph.

(4) The inorganic filler needs to have an aspect ratio (the average particle diameter/thickness ratio) of 10 or higher (preferably 15 or higher), in order to eliminate anisotropy (the differences in the coefficient of linear expansion and mechanical strength between MD and TD), and to improve the dimensional accuracy. The average particle diameter is measured with a laser diffraction particle diameter distribution analyzer. MD (mold direction) is the flow direction during forming, and TD (transverse direction) is the direction perpendicular to the flow direction.

The resin composition containing a suitable amount of a flaky inorganic filler with an aspect ratio of 10 or higher has a decreased mold shrinkage factor, and is capable of forming a formed article that has remarkably improved mechanical characteristics, very small anisotropy, and excellent dimensional accuracy. The upper limit of the aspect ratio is usually about 50.

Examples of flaky inorganic fillers that satisfy the above characteristics (1) to (4) include lamellar graphite, h-boron nitride, γ-boron nitride, t-boron nitride, lamellar boron-nitride and -carbide, and molybdenum disulfide. Among these fillers, lamellar graphite and h-boron nitride are preferable. All of these flaky inorganic fillers are known.

Lamellar graphite and h-boron nitride have the following characteristics.
(i) Lamellar graphite: flexible and highly lubricious; resistant to oxidation even at high temperatures (e.g., in the air at a high temperature of about 600°C); highly resistant to chemicals; highly conductive to heat and electricity (0.0141 cal/cm sec °C); 2.23 to 2.25 in specific gravity; low in coefficient of linear expansion (0.786 x 10⁻⁵/K); extremely high in melting point (3500°C)
(ii) h-BN (hexagonal boron nitride): flexible and highly lubricious (Mohs hardness of 2.0); low in specific gravity (2.7); low in expansion coefficient (not higher than 0.2 x 10⁻⁵/K); highly resistant to chemicals; highly conductive to heat; high in aspect ratio (in some types of h-BN); extremely high in melting point
C-BN (cubic boron nitride) cannot be used because of its excessively high Mohs hardness.

The flaky inorganic filler for use in the present invention may be subjected to a conventional surface treatment. A typical surface treatment is a coupling treatment using a titanate coupling agent, a silane coupling agent, or the like. The coupling treatment further improves the physical properties, such as elongation characteristics, of the formed article of the resin composition according to the present invention.

The flaky inorganic filler, when used in a proportion of about 15 to 50 wt.% relative to the total amount of the resin composition, can impart satisfactory physical properties to the resin composition and its formed article. It is desirable to use 20 to 40 wt.% of the flaky inorganic filler relative to the total amount of the composition of the present invention.

When the flaky inorganic filler is used in a proportion less than 15 wt.%, a mold shrinkage factor of 0.30 or lower cannot be achieved, while when it is used in a proportion exceeding 50 wt.%, the formed article of the resin composition of the present invention is not satisfactory in bending deflection and tensile elongation, among its physical properties.

The resin composition of the present invention may contain, within the range that does not disturb the object of the present invention, various known components, such as a heat stabilizer, lubricant, release agent, pigment, dye, ultraviolet absorber, flame retardant, lubricating agent, filler, and reinforcing agent.

The composition of the present invention can be produced by, for example, supplying a flaky inorganic filler and other components from a side hopper into a heat-resistant resin being melted and kneaded in a twin-screw kneader or the like.

### Formed article of resin composition

The formed article of the present invention can be obtained by molding or extruding the resin composition of the present invention, and has a mold shrinkage factor of 0.30% or lower, a bending deflection of 3.6% or more, and a tensile elongation of 4.3% or more.

The formed article of the present invention can be easily produced by a known forming process using the resin composition of the present invention. For example, the composition can be formed into parts of desired shape by injection molding, extrusion, or other means.

### Substrate film for printed circuit boards

The substrate film for printed circuit boards of the present invention can be obtained by forming a resin composition comprising a specific resin selected from the options for the heat-resistant thermoplastic resin (A) and a specific filler selected from the options for the flaky inorganic filler (B).

Specifically, the film of the present invention can be obtained by forming a resin composition comprising:
(A') a heat-resistant thermoplastic resin that is a blended resin of a polyether ketone resin and polyetherimide, and
(B') a flaky boron nitride that: (1) has a Mohs hardness of 3.0 or lower, (2) has a coefficient of linear expansion not higher than 50 x 10⁻⁵/K, (3) is chemically inert and retains a layer structure to at least 500°C; and (4) has an aspect ratio (the average particle diameter/thickness ratio) of 10 or higher.

Since a resin composition comprising the above blended resin and flaky boron nitride is used, the coefficient of linear expansion of the substrate film of the present invention can be adjusted to a value similar to that of copper foils or like conductor layers, without impairing the characteristics, such as good elongation characteristics and deflection characteristics.

The substrate film of the present invention has a coefficient of linear expansion similar to that of conductor layers, such as copper foils, does not curl when laminated with a conductor layer, and has good elongation characteristics, good deflection characteristics, a low molding shrinkage factor, high heat resistance, and excellent processability for adhesion to a metallic conductor.

Further, the film of the present invention has, with good balance, high levels of characteristics required of substrates for printed circuit boards. Specifically, for example, the film of the present invention has good dimensional accuracy and high solder heat resistance; is not liable to warp, twist, or have other defects; has a low coefficient of thermal expansion; and is excellent in adhesive strength to conductive layers, bending strength, flexibility, and various electrical characteristic, such as dielectric breakdown voltage, dielectric constant, dielectric loss tangent, and volume resistivity.

Therefore, the substrate film for printed circuit boards of the present invention retains high durability and high reliability for a long period of time, and can be used suitably in various electronic and electrical devices.

The polyether ketone resin for use in the heat-resistant thermoplastic resin (A') in the present invention may be selected from those known. Examples of usable polyether ketone resins include those having one or more types of basic repeating units selected from the following:

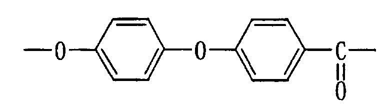

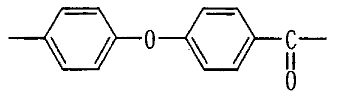

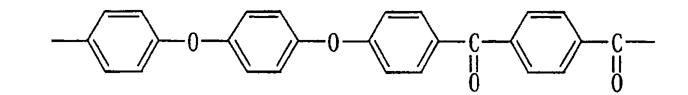

The polyether ketone resin for use in the present invention may have one or more types of repeating units selected from the following:

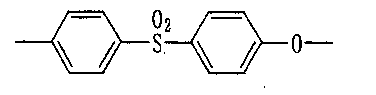

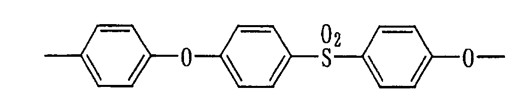

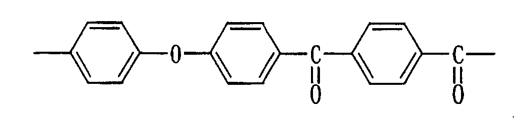

Specific examples of polyether ketone resins include polyether ketone, polyether ether ketone, polyether ketone ketone, polyether ether ketone ketone, and the like.

Commercially available polyether ketone resins are usable in the present invention. Examples of commercially available polyether ketone resins include polyether ether ketone and polyether ketone both manufactured by Victrex Plc under the tradename "Victrex", polyether ketone manufactured by BASF A.G. under the tradename "Ultrapek", polyether ketone manufactured by Hoechst A.G. under the tradename "Hostatec PEK", polyether ketone manufactured by Amoco Corp. under the tradename "ADEL", and the like.

Among these polyether ketone resins, polyether ether ketone, polyether ketone ketone, polyether ether ketone ketone, and the like are preferable, and polyether ether ketone and the like are particularly preferable, considering the heat resistance and other properties of the resulting film.

In, the present invention, the polyether ketone resins may be used either singly or in combination.

The polyetherimide may be selected from those known. Examples of usable polyetherimide include polyimide ether having the repeating units of Formulas (1) and/or (2). 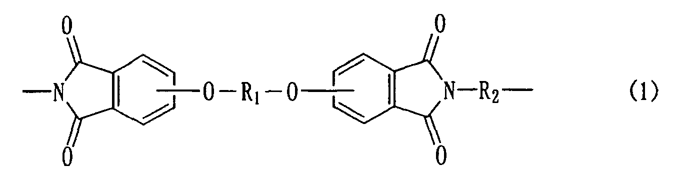 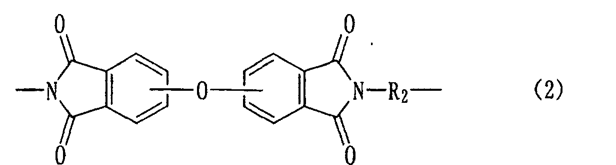 [wherein R₁ represents a C₆ to C₃₀ divalent aromatic hydrocarbon residue or an aliphatic hydrocarbon residue; R₂ is a divalent C₆ to C₂₀ aromatic hydrocarbon residue that may be substituted by a halogen atom, a C₃ to C₂₀ cycloalkylene group, or a group 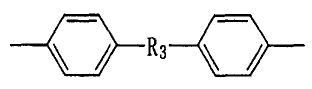 (R₃ represents -S-, -O-, -CO-, -SO₂-, or - (CH₂)ₙ wherein n is an integer of 1 to 5)].

The following are examples of organic groups represented by R₁ or R₂.

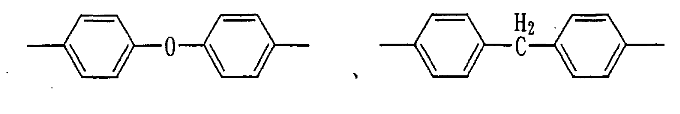

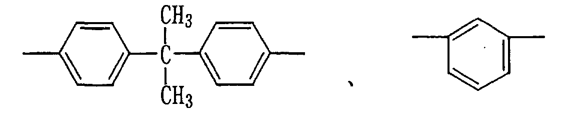

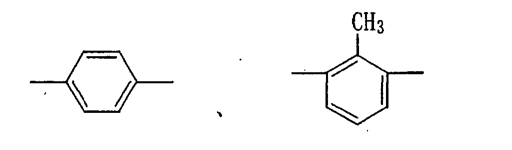

Preferred examples of polyetherimide include those having the following repeating unit:

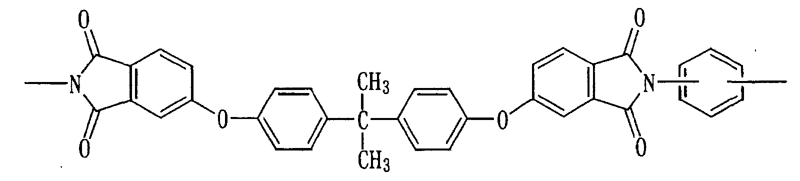

Commercially available polyetherimide, such as polyetherimide manufactured by General Electric Co. under the tradename "Ultem", can be used in the present invention.

The proportions of the polyether ketone resin and polyetherimide can be suitably selected from a wide range. Considering the balance of the heat resistance, mechanical properties (in particular the coefficient of linear expansion), processability for adhesion to a metal conductor, and other characteristics, of the resin composition comprising the two resins and a specific flaky inorganic filler, the proportion of the polyether ketone resin may be 30 to 70 wt.%, preferably 35 to 65 wt.%, relative to the total amount of the two resins, with the remainder being polyetherimide.

The flaky boron nitride (B') for use in the present invention has the following characteristics (1) to (4).

### (1) Mohs hardness of 3.0 or lower, preferably 2.0 or lower

Use of a flaky boron nitride with a Mohs hardness of 3.0 or lower makes it possible to obtain a film having good elongation characteristics, good deflection characteristics, and the like.

### (2) Coefficient of linear expansion not higher than 5.0 x 10⁻⁵/K

When using a flaky boron nitride with a coefficient of linear expansion not higher than 5.0 x 10⁻⁵/K, the coefficient of linear expansion of the film can be easily adjusted to a value similar to that of conductor layers even when the amount of the flaky boron nitride added is changed. The coefficient of linear expansion is measured according to JIS K-7197.

### (3) Ability to be chemically inert and retain a layer structure up to at least 500°C

Generally, when a flaky inorganic filler containing a metal oxide as the main ingredient is added to a resin, the bending deflection and tensile elongation are likely to decrease. This is presumably because the metal oxide reacts with moisture of in the air and is converted to a metal hydroxide, which attacks the main chain structure of the resin and causes deterioration. However, a flaky boron nitride that retains a chemically stable layer structure when heated to at least 500°C does not adversely affect the physical properties, such as bending deflection and tensile elongation, of the film.

As used herein, the expression "chemically inert" means that a layer structure is stable (a layer structure is retained without being broken) during kneading (pelletization) or film extrusion. Whether the layer structure is retained or not is determined from a scanning electron microscope (SEM) photograph.

### (4) Aspect ratio (the average major axis length/thickness) of 10 or higher

A film having homogeneous characteristics without anisotropy, a low mold shrinkage factor, and excellent dimensional accuracy can be obtained by adding a flaky boron nitride with an aspect ratio (the average major axis length/thickness ratio) of 10 or higher, preferably 15 or higher. The upper limit of the aspect ratio is usually about 50.

In the present invention, the aspect ratio is calculated from the major axis length (the maximum diameter) and thickness of the flaky boron nitride measured with a scanning electron microscope.

Examples of flaky boron nitrides that satisfy the above characteristics (1) to (4) include h-boron nitride (hexagonal boron nitride), γ-boron nitride, t-boron nitride, lamellar boron-nitride and -carbide, and the like. Among them, h-boron nitride is preferable. These flaky boron nitrides can be used either singly or in combination.

The flaky boron nitride used in the present invention may be surface-treated. The surface treatment can be carried out in a manner similar to the conventional surface treatment of inorganic fillers, using a coupling agent, such as a titanate coupling agent or a silane coupling agent. The surface treatment further improves the physical properties, such as elongation characteristics, of the film of the present invention.

The proportion of the flaky boron nitride can be selected from a wide range according to conditions, such as the proportions of the polyether ketone resin and polyetherimide, the type of the flaky boron nitride, the thickness of the conductor layer to be laminated on the resulting film, the place of use of the printed circuit board containing the film, and the like. However, for achieving high levels of characteristics, such as the coefficient of linear expansion, elongation characteristics, and mold shrinkage factor, of the film with good balance, the flaky boron nitride can be used in a proportion of 15 to 40 wt.%, preferably 20 to 35 wt.%, relative to the total amount of the blended resin of the polyether ketone resin and polyetherimide, and the flaky boron nitride.

The resin composition forming the substrate film of the present invention may contain, within the range that does not impair the desirable characteristics of the film, a thermoplastic resin, such as polyketone, polyarylate, polysulfone, polyethersulfone, polyphenylene sulfide, or polyphenylene oxide, and/or one or more known resin additives, such as a heat stabilizer, lubricant, release agent, pigment, dye, ultraviolet absorber, flame retardant, plasticizer, lubricating agent, filler, or reinforcing agent.

The resin composition preferably has a knee point of 60 MPa or lower, more preferably 50 MPa or lower, as determined from a stress-strain diagram created according to JIS K7171 (bending test method). The knee point is the point at which the stress-strain diagram forms a curve, i.e., the point at which the resin undergoes transition from a fully elastic state to a plastic deformation state and viscoelastic state.

The above resin composition can be produced by mixing or kneading the essential three components, i.e., a polyether ketone resin, polyetherimide, and a flaky boron nitride, optionally together with additives, by a known process. For example, the components in the form of powders, beads, flakes, or pellets, are mixed or kneaded using a known extruder, kneader, or the like, to produce the resin composition in the form of pellets.

Examples of extruders include single-screw extruders, twin-screw extruders, multiple-screw extruders, and the like. Examples of kneaders include co-kneaders, Banbury mixers, pressure kneaders, twin rolls, and the like.

The substrate film for printed circuit boards of the present invention can be produced by forming the above resin composition into a film by a conventional resin forming process.

For example, the resin composition is formed into an unoriented film by a casting process (T-die process) in which the resin composition is melted, kneaded, extruded in film form from a T-die, cast on the surface of a roll, and cooled; a tubular process in which the resin composition is melted, kneaded, extruded in tube form from a ring die, and air- or water-cooled; or like process.

Further, the unoriented film obtained by the casting process, tubular process, or the like can be uniaxially or biaxially oriented at a 50 to 180°C, and optionally subjected to heat setting at a temperature lower than the melting point, to produce an oriented film.

The substrate film of the present invention may be usually about 5 to about 200 µm thick, preferably about 20 to 125 µm thick, in view of its intended use.

The printed circuit board of the present invention can be obtained by laminating the above substrate film for printed circuit boards with a conductor layer or layers. More specifically, for example, the film may be laminated with a conductive layer on one or both sides, and further, a circuit pattern may be formed on the conductor layer to form a four or more layered structure.

The conductor layer is made of a good electrical conductor, generally copper. Each conductor layer may be usually about 5 to about 50 µm thick, preferably about 10 to about 40 µm thick, in view of its intended use.

The conductive layer can be laminated on the substrate film by any known process, for example, bonding a copper foil by thermocompression at 200°C or higher, preferably at 210 to 250°C; forming a copper layer on the film surface by vapor deposition or electroless plating; or bonding the film and a copper foil via an adhesive layer. Among theses processes, thermocompression bonding of a copper foil is most generally employed.

The forming of the film and thermocompression bonding of a copper foil to the film may be carried out simultaneously.

### BEST MODE FOR CARRYING OUT THE INVENTION

The following Examples and Comparative Examples are provided to illustrate the present invention in further detail.

The heat-resistant resins used in the examples are as follows.
1. Polyether ether ketone: manufactured by Victrex Plc under the treadename "450G"; hereinafter referred to as "PEEK"
2. Polyarylate: manufactured by Unitika, Ltd. under the tradename "U-10"; hereinafter referred to as "PAR"
3. Polyetherimide: manufactured by Japan GE Plastics under the tradename "Ultem 1000-1000"; hereinafter referred to as "PEI"
4. Polyphenylsulfone: manufactured by Teijin Amoco Corp. under the tradename "Radel R"; hereinafter referred to as "PSF"

The flaky inorganic fillers used in the examples are as follows.
1. Flaky boron nitride: h-boron nitride manufactured by Denki Kagaku Kogyo K.K. under the tradename "Denka BN (GP)"; having a Mohs hardness of 2 and a coefficient of linear expansion of 0.24 x 10⁻⁵ /K; capable of maintaining a layer structure at 900°C or lower; having an average major axis length of 6.2 µm and an aspect ratio of 25; hereinafter referred to as "h-BN"
2. Lamellar graphite: manufactured by Nippon Graphite Industries, Ltd. under the tradename "KEX"; having an average particle diameter of 10.4 µm, an aspect ratio of 20, a Mohs hardness of 1 to 2, and a coefficient of linear expansion of 0.79 x 10⁻⁵/K; capable of retaining a layer structure at 600°C or lower; hereinafter referred to as "KEX"
3. Boron nitride powder: manufactured by Denki Kagaku Kogyo K.K. under the tradename "Denka SP-2"; having an average particle diameter of 0.5 µm, a Mohs hardness of 2, a coefficient of linear expansion of 0.24 x 10⁻⁵/K, an average particle diameter of 1.7 µm, and an aspect ratio of 3; hereinafter referred to as "BN powder"
4. Flaky mica: natural mica; manufactured by K.K. Hikawa Kogyo under the tradename "Z-20"; having a Mohs hardness of 2.7 to 3.0 and a coefficient of linear expansion of 0.88 x 10⁻⁵/K; capable of retaining a layer structure at 900°C or lower; having an average particle diameter of 13 µm and an aspect ratio of 40; hereafter referred to as "Z-20"
   In the examples, the tensile elongation, bending strength, bending deflection, mold shrinkage factor, and knee point were measured by the methods described below.

Tensile elongation (%): Measured according to JIS K7161.

Bending strength (MPa) and bending deflection (%): Measured according to JIS K7171.

Mold shrinkage factor (%): A formed article was produced in a mold (90.01 x 49.99 x 3.20 mm) using a film gate, and the mold shrinkage factor was calculated according to the following equation.$\text{Mold shrinkage factor (%) = [(mold size - molded article size)/mold size] x 100}$

The mold shrinkage factor was measured in two directions, i.e., MD (mold direction (flow direction)) and TD (transverse direction (the direction perpendicular to the flow direction)).

Knee point (MPa): Determined from a stress-strain diagram created according to the bending test method of JIS K7171.

### Examples of resin compositions comprising (A) a heat-resistant thermoplastic resin and (B) a flaky inorganic filler, and formed articles of the compositions

### Examples 1 to 5 and Comparative Examples 1 to 5

The above heat-resistant resins and flaky inorganic fillers were supplied to a twin-screw extruder (manufactured by Kobe Steel Ltd. under the tradename "KTX46") in the proportions (wt.%) shown in Table 1, to prepare pellets of resin compositions of the present invention and comparative resin compositions.

**Table 1**

| | | Example | | | | | Comparative Example | | | | |
|---|---|---|---|---|---|---|---|---|---|---|---|
| | | 1 | 2 | 3 | 4 | 5 | 1 | 2 | 3 | 4 | 5 |
| Heat-resistant resin | PEEK | 35 | | | 35 | 35 | 35 | | | 35 | 35 |
| | PSF | 35 | | | 35 | | 35 | | | 35 | |
| | PAR | | 70 | | | 35 | | 70 | | | 35 |
| | PEI | | | 70 | | | | | 70 | | |
| Flaky inorganic filler | h-BN | 30 | 30 | 30 | | | | | | | |
| | KEX | | | | 30 | 30 | | | | | |
| | BN powder | | | | | | 30 | 30 | 30 | | |
| | Z-20 | | | | | | | | | 30 | 30 |

The above compositions were tested for tensile elongation, bending strength, and bending deflection as mechanical strength indices, and mold shrinkage factor as an anisotropy index. Table 2 shows the results.

**Table 2**

| | | Example | | | | | Comparative Example | | | | |
|---|---|---|---|---|---|---|---|---|---|---|---|
| | | 1 | 2 | 3 | 4 | 5 | 1 | 2 | 3 | 4 | 5 |
| Tensile elongation (%) | | 5.0 | 4.5 | 4.6 | 5.2 | 4.6 | 5.1 | 4.6 | 4.7 | 1.7 | 1.5 |
| Bending strength (Mpa) | | 142 | 122 | 113 | 151 | 141 | 104 | 98 | 90 | 107 | 102 |
| Bending deflection (%) | | 5.6* | 5.2 | 5.3 | 5.8* | 5.7 | 5.7* | 5.3 | 5.4 | 2.2 | 1.9 |
| Mold shrink-age factor (%) | MI | 0.27 | 0.24 | 0.25 | 0.29 | 0.27 | 0.49 | 0.46 | 0.47 | 0.37 | 0.37 |
| | TD | 0.28 | 0.26 | 0.27 | 0.30 | 0.28 | 0.50 | 0.48 | 0.50 | 0.38 | 0.38 |

Of the bending deflection values shown in Table 2, those marked with * are yield values, which are bending deflection values under the highest stress of the test pieces that were not broken, and the others are breaking values, which are bending deflection values at which the test pieces were broken.

### Examples of substrate films for printed circuit boards obtained by forming resin compositions comprising (A') a heat-resistant thermoplastic resin and (B') a flaky boron nitride

### Example 6 and Comparative Examples 6 to 8

The above heat-resistant resins and flaky inorganic fillers were supplied to a twin-screw extruder (manufactured by Kobe Steel Ltd. under the tradename "KTX46") in the proportions (wt.%) shown in Table 3, to prepare pellets of the resin compositions of the present invention and comparative resin compositions.

The obtained pellets were injection-molded, and the formed articles were tested for tensile elongation, bending strength, and bending deflection as mechanical strength indices, mold shrinkage factor as an anisotropy index, and knee point. Table 3 shows the results.

**Table 3**

| | | Example | Comparative Example | | |
|---|---|---|---|---|---|
| | | 6 | 6 | 7 | 8 |
| Heat-resistant resin | PEEK | 37.5 | 37.5 | 75.0 | 37.5 |
| | PEI | 37.5 | 37.5 | | 37.5 |
| Flaky inorganic filler | h-BN | 25.0 | | 25.0 | |
| | BN powder | | | | 25.0 |
| | Z-20 | | 25.0 | | |
| Tensile elongation (%) | | 4.8 | 2.8 | 6.0 | 4.9 |
| Bending strength (Mpa) | | 146 | 120 | 166 | 135 |
| Bending deflection (%) | | 6.2 | 2.2 | 5.8* | 6.4 |
| Mold shrinkage factor (%) | MD | 0.22 | 0.47 | 0.62 | 0.52 |
| | TD | 0.24 | 0.50 | 0.63 | 0.55 |
| Knee point (Mpa) | | 42 | 160 | 38 | 44 |

Of the bending deflection values shown in Table 3, the one marked with * is a yield value, which is a bending deflection value under the highest stress of the test piece that was not broken, and the others are breaking values, which are bending deflection values at which the test pieces were broken.

### Example 7

Pellets of a resin composition was prepared by following the procedure of Example 6 and using 38.5 parts by weight of PEEK, 38.5 parts by weight of PEI, and 23 parts by weight of h-BN. The pellets were extruded using a coathanger die extruder to produce a 75 µm-thick film. The obtained film was evaluated by the following methods. Table 4 shows the results.

(1) Film extrudability: The molten resin composition extruded from the T-die was wound, and evaluated as "a" when the extruded composition was processable as a film; as "b" when the composition could be taken off but was poor in appearance or had air bubbles; and as "c" when the composition could not be taken off.

(2) Toughness (flexibility): The film was bent at 180 degrees to test whether brittle fracture occurred or not, and evaluated as "c" when the film cracked like glass or partially or completely broke at the bent portion; and as "a" when the film had no cracking or breaking.

(3) Cu lamination curling properties: A 35 µm-thick electrolytic Cu foil was compression-bonded to the film at 210°C for 30 minutes, at a pressure of 30 kg/cm². The curling of the obtained Cu-laminated film was inspected, and evaluated as "a" when the radius of curvature was 200 mm or more; as "b" when the radius of curvature was 100 to 200 mm; and as "c" when the radius of curvature was 100 mm or less.

(4) Tensile strength: A tensile test was carried out according to JIS K 7311 at a rate of 300 mm/min, to measure the tensile strength.

(5) Coefficient of linear expansion: The coefficient of linear expansion at 20 to 130°C was measured, using SSC5200H Disk Station, a TMA120 thermomechanical analyzer manufactured by Seiko Instruments Inc. The direction of taking off the film is indicated as MD, and the direction perpendicular to MD was indicated as TD.

(6) TMA elongation: Using a TMA120 thermomechanical analyzer, the elongation (%) of a strip specimen (5 x 25 mm) was measured under a tensile load of 50 g, with heating from 20 to 250°C at a rate of 5°C/min.

(7) Solder heat resistance: The film was dipped in a solder bath at 260°C for 10 seconds, and inspected for deformation. The film was evaluated as "c" when it was severely deformed; as "b" when it was slightly deformed; and as "a" when it had almost no deformation.

### Comparative Example 9

A film was produced by following the procedure of Example 7 except using Z-20 in place of h-BN, and evaluated. Table 4 shows the results.

### Comparative Example 10

A film was produced by following the procedure of Example 7 except using only PEEK in place of the mixture of PEEK and PEI, and evaluated. Table 4 shows the results.

### Comparative Example 11

A film was prepared by following the procedure of Example 7 except using BN powder in place of h-BN, and evaluated. Table 4 shows the results.

**Table 4**

| | | Example | Comparative Example | | |
|---|---|---|---|---|---|
| | | 7 | 9 | 10 | 11 |
| Film extrudability | | a | c | a | a |
| Toughness (flexibility) | | a | c | a | a |
| Cu lamination curling properties | | a | b | c | c |
| Tensile strength (kg /mm² ) | | 19.1 | 5.0 | 21.2 | 16.2 |
| Coefficient of linear expansion (x 10⁻⁵/K) | MD | 2.0 | 3.6 | 4.8 | 4.5 |
| | TD | 2.3 | 4.0 | 5.3 | 4.9 |
| TMA elongation (%) | | 1.8 | 6.0 | 1.4 | 2.6 |
| Solder heat resistance | | a | c | a | b |

Table 4 reveals that the film of the present invention has a coefficient of linear expansion similar to that of copper foils; does not curl when laminated with a copper foil; has good elongation characteristics, good deflection characteristics, a low mold shrinkage factor, and the like; and is excellent in heat resistance and processability for adhesion to a metallic conductor.

### Example 8

A 15 µm-thick rolled copper foil was placed on both sides of a 25 µm-thick film produced by following the procedure of Example 7, and compression-bonded to the film using a double belt press at a temperature of 225°C and a pressure of 30 kg/cm² for 10 minutes, giving a copper-clad laminate according to the present invention.

One of the copper layers of this copper-clad laminate was etched to form a circuit pattern. Then, a 25 µm-thick polyimide film provided with a phenol adhesive was applied over the circuit pattern to form a protective layer. Thus, a flexible printed circuit board was produced.

The flexibility of the flexible printed circuit board was evaluated by counting, as an index of flexibility, the number of times of bending (unit: million) that the printed circuit board could withstand. Specifically, the number of times of bending was counted according to IPC-243B, at a bending rate of 1500 times/min, a stroke of 25 mm, a curvature of 5 mm, and a current of 1 mA. The counting was continued until the resistance reached 1800 mΩ. Table 5 shows the results.

### Comparative Example 12

A resin composition prepared in the same manner as in Comparative Example 6 was formed into a 25 µm-thick film. Using this film, the procedure of Example 8 was repeated to produce a flexible printed circuit board.

### Comparative Example 13

A resin composition prepared in the same manner as in Comparative Example 7 was formed into a 25 µm-thick film. Using this film, the procedure of Example 8 was repeated to produce a flexible printed circuit board.

The flexibility of the flexible printed circuit boards obtained in Comparative Examples 12 to 13 was evaluated by counting the number of times of bending (unit: million) that each printed circuit board could withstand, in the same manner as above. Table 5 shows the results.

**Table 5**

| | Example | Comparative Example | |
|---|---|---|---|
| | 8 | 12 | 13 |
| Number of bending (unit: million) | 350 | 220 | 270 |

Since the resin composition of the present invention comprises a specific heat-resistant resin and a specific flaky inorganic filler, the formed article obtained therefrom has a low mold shrinkage factor of 0.30% or lower, and thus has a substantially lowered coefficient of linear expansion and is excellent in dimensional stability in the range from room temperature to higher temperatures. The formed article of the resin composition of the present invention is free from the conventional drawbacks regarding bending deflection and tensile elongation, while retaining high mechanical strength.

Accordingly, the resin composition of the present invention can be suitably used for forming or sealing electrical, electronic, and mechanical parts for industrial devices, such as communication devices and automotive devices.

The substrate film for printed circuit boards of the present invention has a coefficient of linear expansion similar to that of conductive layers; does not curl when laminated with a conductive layer; has good elongation characteristics, good deflection characteristics, a low mold shrinkage factor, and the like; and is excellent in heat resistance and processability for adhesion to a metallic conductor.

Moreover, the substrate film for printed circuit boards of the present invention has, with good balance, high levels of characteristics required of substrates for printed circuit boards. Specifically, for example, the film of the present invention has good dimensional accuracy and good solder heat resistance; is unlikely to warp, twist, or have other defects; has a low coefficient of thermal expansion; is high in mechanical strength characteristics, such as adhesion strength to a copper foil and bending strength; has excellent flexibility; and is excellent in various electrical characteristics, such as dielectric breakdown voltage, dielectric constant, dielectric loss tangent, and volume resistivity.

Therefore, the substrate film for printed circuit boards of the present invention retains high durability and high reliability for a long period of time, and can be used suitably in various electronic and electrical devices.

## Claims

1. A resin composition comprising:
(A) at least one heat-resistant thermoplastic resin selected from the group consisting of a polyketone resin, a polyimide resin, polyethernitrile, polybenzimidazole, polyphenylene sulfide, polysulfone, polyethersulfone, polyarylate, a liquid crystal polyester resin, and 1,4-polyphenylene; and
(B) a flaky inorganic filler that: (1) has a Mohs hardness of 3.0 or lower, (2) has a coefficient of linear expansion not higher than 5.0 x 10⁻⁵/K, (3) is chemically inert and retains a layer structure to at least 500°C, and (4) has an aspect ratio (the average particle diameter/thickness ratio) of 10 or higher.

2. A resin composition according to Claim 1, wherein the flaky inorganic filler (B) is at least one member selected from the group consisting of lamellar graphite, h-boron nitride, γ-boron nitride, t-boron nitride, lamellar boron-nitride and -carbide, and molybdenum disulfide.

3. A resin composition according to Claim 1, wherein the proportion of the flaky inorganic filler (B) in the composition is 15 to 50 wt.%.

4. A resin composition according to Claim 1, wherein the flaky inorganic filler has been subjected to a coupling treatment.

5. A resin composition according to Claim 1, wherein the polyketone resin is at least one member selected from the group consisting of polyether ether ketone, polyether ketone, polyketone, and polyether ketone ketone.

6. A resin composition according to Claim 1, wherein the polyimide resin is at least one member selected from the group consisting of polyimide, polyamide-imide, and polyetherimide.

7. A resin composition according to Claim 1, wherein the component (A) is a polymer alloy of at least one heat-resistant crystalline resin selected from the group consisting of a polyketone resin, polyimide, polyamide-imide, polyethernitrile, polybenzimidazole, polyphenylene sulfide, a liquid crystal polyester resin, and 1,4-polyphenylene, and at least one heat-resistant amorphous resin selected from the group consisting of polysulfone, polyethersulfone, polyetherimide, and polyarylate.

8. A formed article obtainable by forming a resin composition according to Claim 1, the formed article having a mold shrinkage factor of 0.30% or lower, a bending deflection of 3.6% or more, and a tensile elongation of 4.3% or more.

9. A substrate film for printed circuit boards, obtainable by forming a resin composition comprising:
(A') a heat-resistant thermoplastic resin that is a blended resin of a polyether ketone resin and polyetherimide; and
(B') a flaky boron nitride that: (1) has a Mohs hardness of 3.0 or lower, (2) has a coefficient of linear expansion not higher than 5.0 x 10⁻⁵/K, (3) is chemically inert and retains a layer structure to at least 500°C; and (4) has an aspect ratio (the average particle diameter/thickness ratio) of 10 or lower.

10. A film according to Claim 9, wherein the proportion of the polyether ketone resin in the blended resin is 30 to 70 wt.%.

11. A film according to Claim 9, wherein the polyether ketone resin is at least one member selected from the group consisting of polyether ketone, polyether ether ketone, polyether ketone ketone, and polyether ether ketone ketone.

12. A film according to Claim 9, wherein the proportion of the flaky boron nitride (B') in the composition is 15 to 40 wt.%.

13. A film according to Claim 9, wherein the flaky boron nitride (B') is at least one member selected from the group consisting of h-boron nitride, γ-boron nitride, t-boron nitride, and lamellar boron-nitride and-carbide.

14. A resin composition according to Claim 9, wherein the knee point of the resin composition is 60 MPa or less.

15. A printed circuit board comprising a substrate film according to Claim 9 and a conductor layer formed on the substrate film.

16. A printed circuit board according to Claim 15, wherein the conductor layer is a copper foil.

17. A printed circuit board comprising a substrate film according to Claim 9 and a conductor layer formed on the substrate film, the conductor layer having a circuit pattern.
